# EUROPEAN PATENT APPLICATION

(11) **EP 1 860 686 A2**
(43) Date of publication of application: **28.11.2007**
(21) Application number: 06125067.6
(22) Date of filing: 30.11.2006
(51) Int. Cl.: H01L 21/28, H01L 21/336, H01L 21/8246, H01L 21/8247, H01L 27/115, H01L 29/788, H01L 29/792, G11C 16/04, H01L 29/423

(54) **Semiconductor memory device having a recess-type control gate electrode and method of fabricating the semiconductor memory device**

(30) Priority: 26.05.2006 KR 20060047528
(71) Applicant: Samsung Electronics Co., Ltd., Suwon-si, Gyeonggi-Do (KR)
(72) Inventor: Park, Yoon-dong, Gyeonggi-do (KR); Koo, June-mo, Gyeonggi-do (KR); Cho, Kyoung-lae, Gyeonggi-do (KR)
(74) Representative: Greene, Simon Kenneth

(57) **Abstract**

A semiconductor memory device having a high operating speed and attaining high integration, and an economical method of fabricating the same are provided. The device includes a semiconductor substrate (105) and a control gate (160) electrode recessed inside the semiconductor substrate. A storage node layer (140) is interposed between a sidewall of the control gate electrode and the semiconductor substrate, and a tunneling insulating layer (130) is disposed between the storage node layer and the semiconductor substrate. A blocking insulating layer (150) is placed between the storage node layer and the control gate electrode. First and second channel regions (110a,110b) are formed around a surface of the semiconductor substrate under the tunneling insulating layer to surround the control gate electrode, and are separated by a pair of facing separation insulating layers (125a,125b).

## Description

### BACKGROUND OF THE INVENTION

The present invention relates to a semiconductor memory device and a method of fabricating the same, and more particularly to a semiconductor memory device having a recess-type control gate electrode and a method of fabricating the semiconductor memory device.

In line with the current trend of reducing the size and increasing the operation speed of semiconductor products, semiconductor memory devices used for the semiconductor products can be further integrated to attain high operation speed. Accordingly, a semiconductor memory device having a three dimensional structure instead of a conventional planar-type structure has been introduced. The semiconductor memory device having the three dimensional structure may have a recess-type control gate electrode that extends inside a semiconductor substrate.

The semiconductor memory device having the three-dimensional structure has a channel area wider than a semiconductor memory device having a planar-type structure, and thus has a faster operating speed. However, in the semiconductor memory device having the three-dimensional structure, a unit cell is operated by unit bits while occupying a large area.

Therefore, the further integration increase of the three-dimensional semiconductor memory device is limited. Moreover, a source region and a drain region still occupy wide areas in the semiconductor memory device having the three dimensional structure. Particularly, the source region and the drain region are alternately disposed to occupy larger areas even in a NAND-type semiconductor memory device that is suitable for integration, which thus limits the integration increase.

### SUMMARY OF THE INVENTION

According to an aspect of the present invention, there is provided a semiconductor memory device including a semiconductor substrate. A control gate electrode is recessed inside the semiconductor substrate, and a storage node is layer interposed between a sidewall of the control gate electrode and the semiconductor substrate. A tunneling insulating layer is disposed between the storage node layer and the semiconductor substrate, and a blocking insulating layer is formed between the storage node layer and the control gate electrode. First and second channel regions are formed around a surface of the semiconductor substrate under the tunneling insulating layer to surround the control gate electrode, and are separated by a pair of facing separation insulating layers.

In this case, the control gate electrode may have a cylindrical, elliptical, or polygonal shape. Also, the storage node layer, the tunneling insulating layer, and the blocking insulating layer are formed along the sidewall of the control gate electrode.

The semiconductor memory device further includes a buried insulating layer interposed between a bottom of the control gate electrode and the semiconductor substrate, and thicker than the tunneling insulating layer.

According to another aspect of the present invention, there is provided a semiconductor memory device including a semiconductor substrate. A plurality of control gate electrodes are respectively recessed inside the semiconductor substrate, and a plurality of storage node layers are each interposed between the sidewalls of the plurality of control gate electrodes and the semiconductor substrate. A plurality of tunneling insulating layers are each interposed between the plurality of storage node layers and the semiconductor substrate, and adjacent pairs of the plurality of storage node layers contact each other to separate the semiconductor substrate into first and second regions. A plurality of blocking insulating layers are each interposed between the plurality of storage node layer and the plurality of control gate electrodes. Also, a continuous first channel region surrounds portions of sidewalls of the plurality of control gate electrodes, around the surface of the first region of the semiconductor substrate. A continuous second channel region surrounds the other portions of the sidewalls of the plurality of control gate electrodes around the surface of the second region of the semiconductor substrate.

According to still another aspect of the present invention, there is provided a method of fabricating a semiconductor memory device including etching a semiconductor substrate to form a plurality of holes. A plurality of tunneling insulating layers are formed on semiconductor substrate portions of sidewalls of the plurality of holes by making adjacent pairs of the plurality of tunneling insulating layers contact each other to separate the semiconductor substrate into first and second regions. After forming a plurality of storage node layers on the plurality of tunneling insulating layers, blocking insulating layers are formed on the storage node layers. Also, control gate electrodes are formed on the blocking insulating layers to be filled into the plurality of holes and recessed inside the semiconductor substrate.

In this case, the method further includes annealing the semiconductor substrate having the plurality of holes by using hydrogen vapors.

The present invention provides a semiconductor memory device suitable for a relatively high operation speed and high integration.

The present invention also provides a relatively economic method of fabricating the semiconductor memory device.

### BRIEF DESCRIPTION OF THE DRAWINGS

The above and other features and advantages of the present invention will become more apparent by describing in detail exemplary embodiments thereof with reference to the attached drawings in which:
FIG. 1 is a plan view illustrating a semiconductor memory device according to a first embodiment of the present invention;
FIG. 2 is a partially cutaway perspective view illustrating the semiconductor memory device according to the first embodiment of the present invention;
FIG. 3 is a plan view illustrating a semiconductor memory device according to a second embodiment of the present invention;
FIG. 4 is a partially cutaway perspective view illustrating the semiconductor memory device according to the second embodiment of the present invention;
FIG. 5 is a plan view illustrating a semiconductor memory device according to a third embodiment of the present invention;
FIG. 6 is a partially cutaway perspective view illustrating the semiconductor memory device according to the third embodiment of the present invention;
FIG. 7 is a plan view illustrating a semiconductor memory device according to a fourth embodiment of the present invention;
FIG. 8 is a plan view illustrating a semiconductor memory device according to a fifth embodiment of the present invention;
FIG. 9 is a partially cutaway perspective view illustrating the semiconductor memory device according to the fifth embodiment of the present invention;
FIG. 10 is a plan view illustrating a semiconductor memory device according to a sixth embodiment of the present invention;
FIGS. 11 through 18 are plan views and sectional views for illustrating a method of fabricating a semiconductor memory device according to an embodiment of the present invention;
FIG. 19 illustrates simulation results of current density distribution in the semiconductor memory device of FIG. 1; and
FIG. 20 illustrates simulation results of current density distribution in the semiconductor memory device of FIG. 5.

### DETAILED DESCRIPTION OF THE INVENTION

The present invention will now be described more fully with reference to the accompanying drawings, in which exemplary embodiments of the invention are shown. The invention may, however, be embodied in many different forms and should not be construed as being limited to the embodiments set forth herein; rather, these embodiments are provided so that this disclosure will be thorough and complete, and will fully convey the concept of the invention to those skilled in the art. In the drawings, the thicknesses of layers and regions are exaggerated for clarity.

### Structure

A semiconductor memory device according to the embodiments of the present invention has a three-dimensional structure. For example, in the semiconductor memory device, a control gate electrode extends inside a semiconductor substrate. The control gate electrode may be of a recess type or a trench type, but the scope of the present invention is not limited to such structure.

The semiconductor memory device according to the embodiments of the present invention may be a non-volatile memory device, e.g., a flash memory or a SONOS memory.

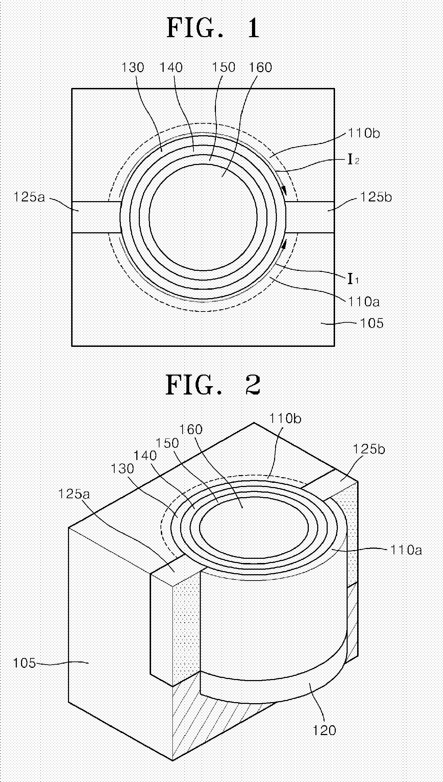

FIG. 1 is a plan view illustrating a semiconductor memory device according to a first embodiment of the present invention, and FIG. 2 is a partially cutaway perspective view illustrating the semiconductor memory device of FIG. 1.

Referring to FIGS. 1 and 2, the semiconductor memory device is formed using a semiconductor substrate 105, and includes first and second channel regions 110a and 110b, a tunneling insulating layer 130, a storage node layer 140, a blocking insulating layer 150 and a control gate electrode 160. The semiconductor memory device commonly controls the pair of first and second channel regions 110a and 110b using the single control gate electrode 160. However, the pair of first and second channel regions 110a and 110b are separated from each other by a pair of separation insulating layers 125a and 125b. Selectively, the semiconductor memory device may further include a buried insulating layer 120.

More specifically, the semiconductor substrate 105 may include a bulk semiconductor wafer, e.g., a silicon wafer, a germanium wafer, or a silicon-germanium wafer. As another example, the semiconductor substrate 105 may further include an epitaxial layer on a bulk semiconductor wafer.

The control gate electrode 160 is recessed inside the semiconductor substrate 105. The control gate electrode 160 is cylindrically shaped and, therefore, can induce a radial electric field. The control gate electrode 160 may be shaped symmetrically about a line that connects the separation insulating layers 125a and 125b. However, regardless of FIGS. 1 and 2, the control gate electrode 160 may have an elliptical bar shape.

The storage node layer 140 is interposed between a sidewall of the control gate electrode 160 and the semiconductor substrate 105. The storage node layer 140 is used as a charge storage medium. For example, the storage node layer 140 may include a polysilicon layer, a silicon nitride layer, metal or silicon dots, or metal or silicon nano-crystals. Especially, the silicon nitride layer, metal or silicon dots, or metal or silicon nano-crystals may be used as a local charge trap layer.

The tunneling insulating layer 130 is interposed between the storage node layer 140 and the semiconductor substrate 105. The tunneling insulating layer 130 is used as a tunneling path of charges, and has a proper thickness according to an operation voltage. For example, the tunneling insulating layer 130 may include an oxide layer, a nitride layer or a high-k dielectric layer. The blocking insulating layer 150 isolates the storage node layer 140 from the control gate electrode 160 by being interposed between them. For example, the blocking insulating layer 150 may include an oxide layer, a nitride layer, or a high-k dielectric layer.

The tunneling insulating layer 130, the storage node layer 140, and the blocking insulating layer 150 may be formed along a sidewall of the control gate electrode 160. That is, the blocking insulating layer 150 surrounds the control gate electrode 160, the storage node layer 140 surrounds the blocking insulating layer 150, and the tunneling insulating layer 130 surrounds the storage node layer 140. Accordingly, the tunneling insulating layer 130, the storage node layer 140, and the blocking insulating layer 150 may have a hollowed cylindrical shape.

The pair of first and second channel regions 110a and 110b are formed around a surface of the semiconductor substrate 105 under the tunneling insulating layer 130 so as to surround the sidewall of the control gate electrode 160. The first and second channel regions 110a and 110b are separated by the pair of separation insulating layers 125a and 125b that face each other. For example, the first channel region 110a is disposed under the separation insulating layers 125a and 125b, and the second channel region 110b is disposed over the separation insulating layers 125a and 125b. For example, the separation insulating layers 125a and 125b are connected to the tunneling insulating layer 130, and include an oxide layer, a nitride layer, or a high-k dielectric layer.

The buried insulating layer 120 is interposed between a bottom of the control gate electrode 160 and the semiconductor substrate 105. The buried insulating layer 120 may be thicker than the tunneling insulating layer 130 so as not to form a channel in the bottom area of the semiconductor substrate 105. Thus, the first and second channel regions 110a and 110b are not connected even in the bottom area of the semiconductor substrate 105.

The semiconductor memory device uses the first and second channel regions 110a and 110b as separate bit lines, and the control gate electrode 160 as a common word line. In this case, four corner portions of the first and second channel regions 110a and 110b may be used as I/O ports. That is, the flow of a first current I1 is permitted through the first channel region 110a, and the flow of a second current I2 is permitted through the second channel region 110b.

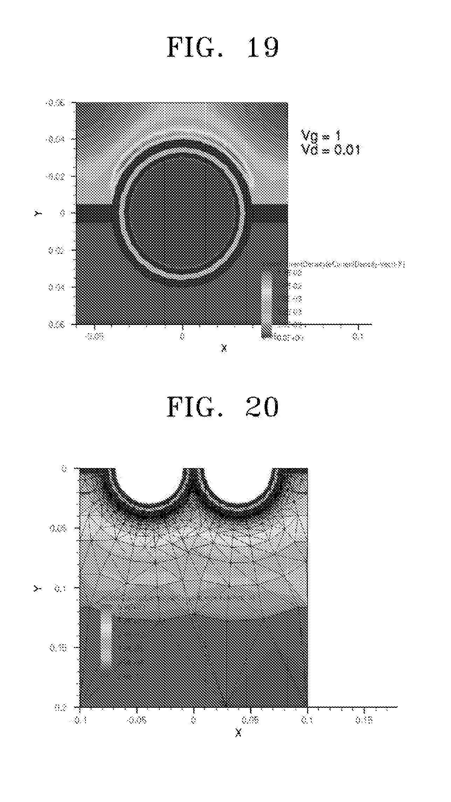

A simulation performed with respect to the current density illustrated in FIG. 19 supports the result of the foregoing operation. In FIG. 19, a color tone distribution displays a distribution of the current density. Also, the control gate electrode 160 of FIG. 1 is supplied with a voltage of 1V (Vg=1), and both ends of the second channel region 110b of FIG. 1 are supplied with a voltage of 0.01V (Vd=0.01). Referring to FIG. 19, it can be noted that a high current density region is formed similarly to the first and second channel regions 110a and 110b of FIGS. 1 and 2. The result of the simulation shows that the flow of the first and second currents 11 and 12 can be induced to the channel regions 110a and 110b.

Meanwhile, the storage node layer 140 is ring-shaped, but portions facing the first and second channel regions 110a and 110b may be local charge storage layers, respectively. Therefore, the semiconductor memory device can process 2 bits data even in a single-level operation. Furthermore, the channel regions 110a and 110b can have larger areas by adjusting the vertical depth, which in turn increases the operation speed of the semiconductor memory device.

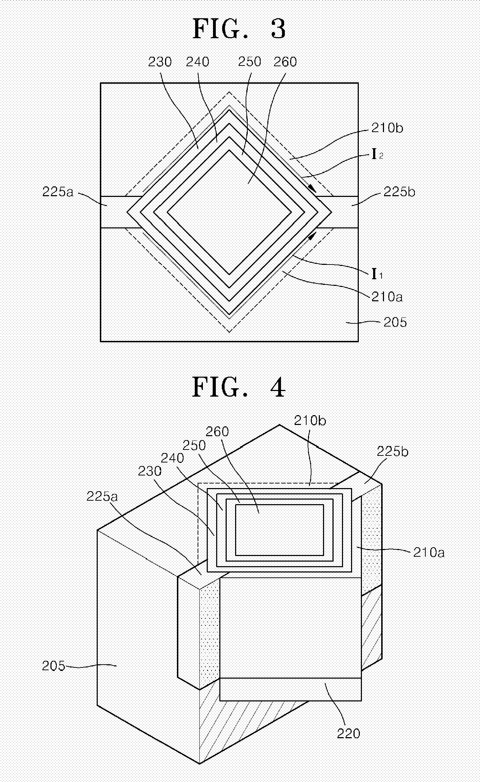

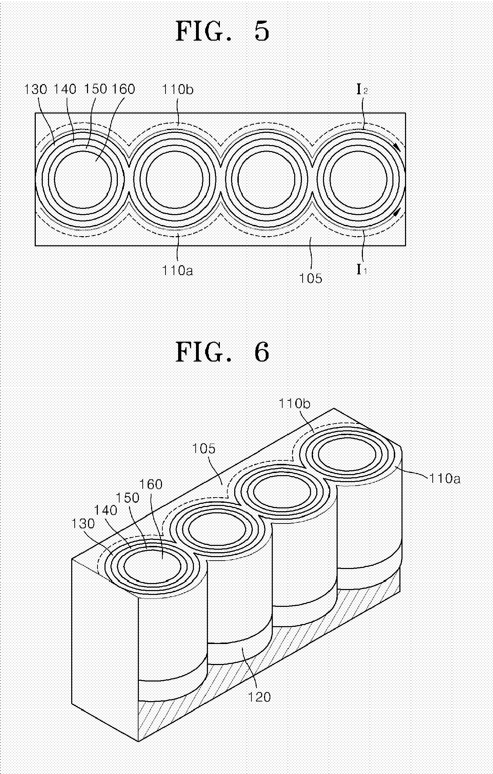

FIG. 3 is a plan view illustrating a semiconductor memory device according to a second embodiment of the present invention, and FIG. 4 is a partially cutaway perspective view illustrating the semiconductor memory device of FIG. 3. The semiconductor memory device illustrated in FIGS. 3 and 4 has only a different shape from that illustrated in FIGS. 1 and 2. Therefore, and thus repeated descriptions of the elements will not be provided.

Referring to FIGS. 3 and 4, a control gate electrode 260 has a rectangular bar shape and is recessed inside a semiconductor substrate 205. The control gate electrode 260 may, however, have other polygonal shapes. A blocking insulating layer 250, a storage node layer 240, and a tunneling insulating layer 230 are formed along the rectangular bar-shaped control gate electrode 260.

A pair of channel regions 210a and 210b surround the rectangular bar shaped control gate electrode 260, and are separated from each other by a pair of separation insulating layers 225a and 225b. For example, the pair of separation insulating layers 225a and 225b may be adjacent to facing corners of the rectangular bar shaped control gate electrode 260. A bottom of the control gate electrode 260 may be isolated from the semiconductor substrate 205 by using a buried insulating layer 220 thicker than the tunneling insulating layer 230.

FIG. 5 is a plan view illustrating a semiconductor memory device according to a third embodiment of the present invention, and FIG. 6 is a partially cutaway perspective view illustrating the semiconductor memory device of FIG. 5. The semiconductor memory device according to the third embodiment illustrated in FIGS. 5 and 6 employs the semiconductor memory device illustrated in FIGS. 1 and 2 as a unit cell, and a plurality of such unit cells are NAND-type connected. The same reference numerals like in FIGS. 1 and 2 denote the same elements, and thus their descriptions will not be repeated.

Referring to FIGS. 5 and 6, a plurality of control gate electrodes 160, a plurality of blocking insulating layers 150 and a plurality of storage node layers 140 are separately formed in the plurality of unit cells, respectively. However, the plurality of tunneling insulating layers 130 are formed such that adjacent pairs contact each other. That is, end portions of the tunneling insulating layers 130 of the plurality of unit cells are connected to one another, thereby forming a continuous shape. Accordingly, the semiconductor substrate 105 may be separated into an upper region over the plurality of tunneling insulating layers 130 and a lower region under the plurality of tunneling insulating layer.

Even though the plurality of tunneling insulating layers 130 of the adjacent unit cells contact each other directly or are overlapped in FIGS. 5 and 6, the separation insulating layers 125a and 125b may be interposed as illustrated in FIGS. 1 and 2. Otherwise, it may be understood that the contacting portions of the plurality of tunneling insulating layers 130 of adjacent unit cells correspond to the separation insulating layers 125a and 125b of FIGS. 1 and 2.

Since the end portions of the plurality of tunneling insulating layers 130 of the unit cells are connected to each other, the first channel regions 110a of the unit cells in the lower region of the semiconductor substrate 105 are connected to each other. Similarly, the second channel regions 110b of the unit cells in the upper region of the semiconductor substrate 105 are continuously connected to each other. Consequently, the first channel regions 110a of the unit cells can be connected to each other without separately requiring source regions and drain regions, and allow the flow of the second current 12. Similarly, the second channel regions 110b of the unit cells can be connected to each other without separately requiring source regions and drain regions, and allow the flow of the second current I2.

Because the plurality of control gate electrodes 160 develop a radial electric field, the channel regions 110a and 110b of the unit cells can be mutually connected without requiring the source region and drain region. Simulation results with respect to the current density as illustrated in FIG. 20 supports such a fact. Referring to FIG. 20, a high current density region similarly shaped to the channel regions 110a and 110b of FIGS. 5 and 6 is formed within the semiconductor substrate 105. Therefore, by using the radial electric field, the continuing channel regions 110a and 110b can be formed without the source region and the drain region.

Although four unit cells are illustrated in FIGS. 5 and 6, the present invention is not limited thereto. Accordingly, the semiconductor memory device may be a single NAND-type string, and the number of the unit cells within a single string can be appropriately selected.

The semiconductor memory device according to the current embodiment has a NAND structure with no source region and drain region, so that an occupied area can be greatly decreased as compared with the conventional NAND structure. Thus, the semiconductor memory device can have significantly high integration. Moreover, the semiconductor memory device can process 2-bits data even in the case of a single-level operation, thereby being possible to achieve a high operating speed.

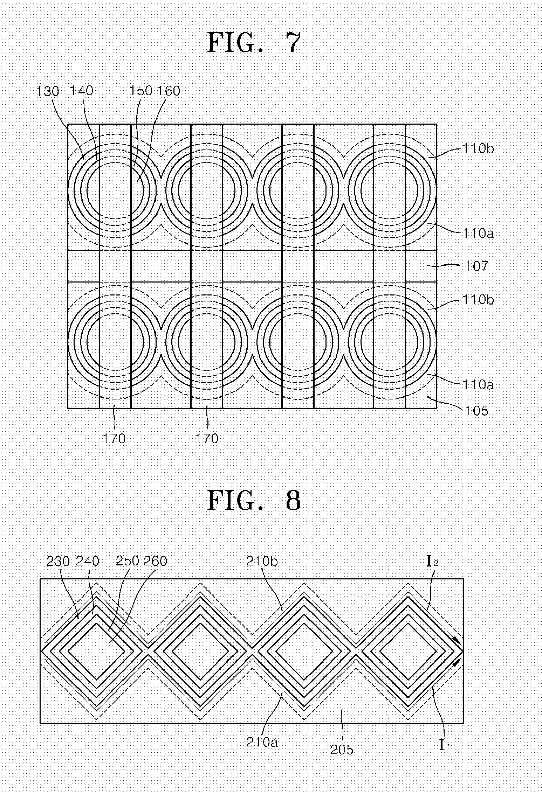

FIG. 7 is a plan view illustrating a semiconductor memory device according to a fourth embodiment of the present invention. The fourth embodiment illustrated in FIG. 7 uses the semiconductor memory device illustrated in FIG. 5 as one string, and two strings are arranged as an array. Therefore, like reference numerals in FIGS. 5 and 7 denote like elements, and thus repeated descriptions thereof will not be provided.

Referring to FIG. 7, two strings are electrically insulated by a device isolation layer 107. Two pairs of channel regions 110a and 110b may be used as four bit lines. In two strings, control gate electrodes 160 of the same column may be connected to a word line 170. Accordingly, by adequately selecting the word lines 170 and the bit lines, respective unit cells can be operated.

Although two strings are illustrated in FIG. 7, the scope of the present invention is not limited thereto. Furthermore, it is obvious that the number of the unit cells within respective strings can be properly selected.

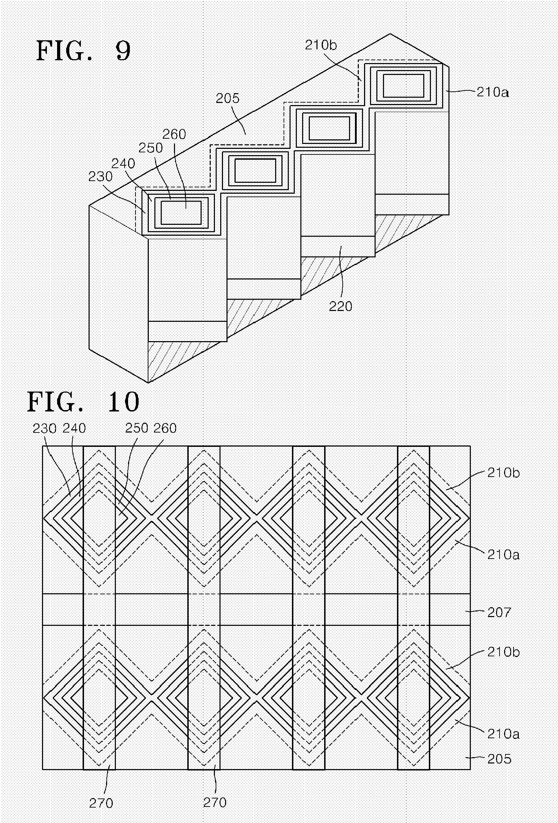

FIG. 8 is a plan view illustrating a semiconductor memory device according to a fifth embodiment of the present invention, and FIG. 9 is a partially cutaway perspective view illustrating the semiconductor memory device of FIG. 8. The semiconductor memory device according to the current embodiment of FIGS. 8 and 9 may use the semiconductor memory device according to the second embodiment illustrated in FIGS. 3 and 4 as a unit cell, and a plurality of such unit cells may be NAND-type connected. Like reference numerals in the fifth and second embodiments denote like elements, and thus their descriptions will not be repeated.

Referring to FIGS. 8 and 9, a plurality of control gate electrodes 260, a plurality of blocking insulating layers 250 and a plurality of storage node layers 240 are separately formed in a plurality of unit cells. However, a plurality of tunneling insulating layers 230 are formed so that adjacent pairs contact each other. That is, the plurality of tunneling insulating layers 230 of the unit cells are connected via respective corners, thereby making a single continuous form. Thus, the semiconductor substrate 205 can be separated into an upper region over the tunneling insulating layer 230 and a lower region under the tunneling insulating layer 230.

Even though the tunneling insulating layers 230 of the adjacent unit cells directly contact each other or are overlapped in FIGS. 8 and 9, separation insulating layers 225a and 225b may be interposed as illustrated in FIGS. 3 and 4. Otherwise, it may be understood that the contacting portions of the tunneling insulating layers 230 of the adjacent unit cells correspond to the separation insulating layers 225a and 225b of FIGS. 3 and 4.

Since the corners of the tunneling insulating layers 230 of the unit cells are connected to each other, first channel regions 210a of the unit cells in the lower region of the semiconductor substrate 205 are connected to each other. Similarly, second channel regions 210b of the unit cells in the upper region of the semiconductor substrate 205 are continuously connected to each other. Consequently, the first channel regions 210a of the unit cells can be connected to each other without separately requiring source regions and drain regions, and allow the flow of the first current I1. Similarly, the second channel regions 210b of the unit cells can be connected to each other with no source region and drain region, and allow the flow of the second current 12.

Although four unit cells are illustrated in FIGS. 8 and 9, the scope of the present invention is not limited thereto. Therefore, the semiconductor memory device can be a single NAND-type string, and the number of the unit cells within the single string can be adequately selected.

An operation of the semiconductor memory device according to the current embodiment may be understood from FIGS. 5 and 6.

FIG. 10 is a plan view illustrating a semiconductor memory device according to a sixth embodiment of the present invention. The current embodiment illustrates two strings arranged as an array when using the semiconductor memory device illustrated in FIG. 8 as a single string. Like reference numerals in FIGS. 8 and 10 denote like elements, and thus their descriptions will not be repeated.

Referring to FIG. 10, two strings can be electrically isolated by a device isolating layer 207. Two pairs of channel regions 210a and 210b can be used as four bit lines. In the two strings, control gate electrodes 260 of the same column can be connected to a word line 270. Accordingly, by adequately selecting the word lines 270 and the bit lines, respective unit cells can be operated.

Although two strings are illustrated in FIG. 10, the scope of the present invention is not limited thereto. Furthermore, it is obvious that the number of the unit cells within respective strings can be properly selected.

### Fabrication method

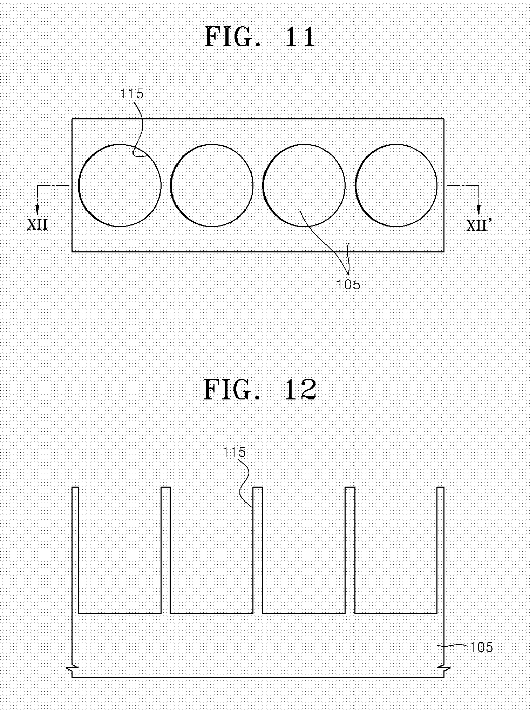

FIGS. 11 through 18 are plan views and sectional views for illustrating a method of fabricating the semiconductor memory device according to an embodiment of the present invention. In this case, the semiconductor memory device may correspond to that illustrated in FIGS. 5 and 6.

Referring to FIGS. 11 and 12, a semiconductor substrate 105 is etched to form a plurality of holes 115. The plurality of holes 115 may be formed by, e.g., photolithography and etching. Although the holes 115 are circularly shaped in FIGS. 11 and 12, they may have another shape, e.g., ellipse or polygon.

The plurality of holes 115 may be enlarged and rounded by annealing the semiconductor substrate 105 in a hydrogen atmosphere after etching. The annealing is performed at a high temperature to generate silicon diffusion of the semiconductor substrate 105, e.g., a silicon wafer, thereby rounding the holes 115.

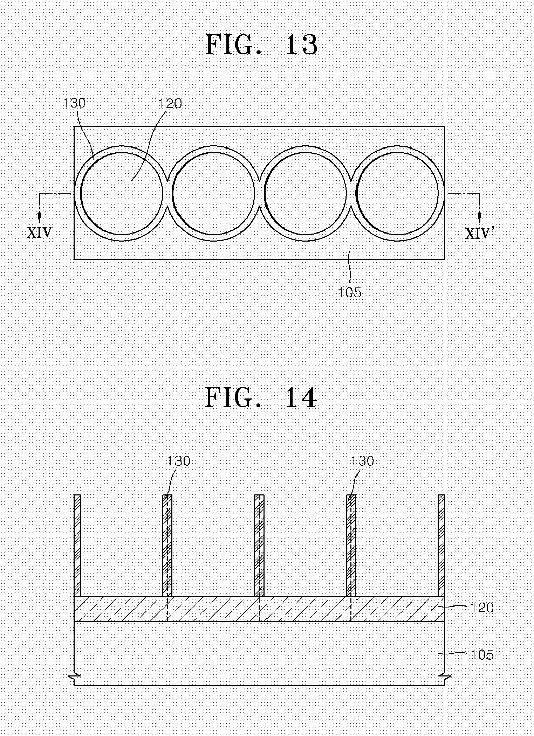

Referring to FIGS. 13 and 14, a plurality of tunneling insulating layers 130 are formed on portions of the semiconductor substrate 105 of the sidewalls of the holes 115 so that adjacent pairs of the plurality of tunneling insulating layers 130 contact each other. Thus, the semiconductor substrate 105 can be separated into an upper region over the tunneling insulating layer 130 and a lower region under the tunneling insulating layer 130. For example, the tunneling insulating layer 130 may be formed by thermally oxidizing the sidewall portions of the semiconductor substrate 105 exposed by the holes 115. In this case, all portions of the semiconductor substrate portion on boundary portions of adjacent holes 115 are oxidized, thereby connecting the tunneling insulating layers 130 to each other.

Before or after forming the tunneling insulating layer 130, a buried insulating layer 120 may be selectively formed on the semiconductor substrate 105 portion of the holes 115. For example, the buried insulating layer 120 may be formed using Chemical Vapor Deposition (CVD) and etching.

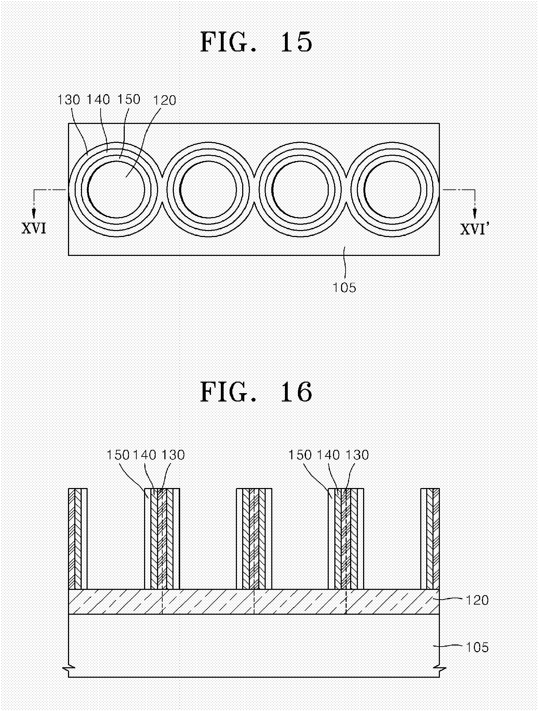

Referring to FIGS. 15 and 16, a plurality of storage node layers 140 are formed on the tunneling insulating layers 130. For example, a polysilicon layer, a silicon nitride layer, metal or silicon dots, or metal or silicon nano-crystals is formed using CVD, and predetermined portions are selectively removed, thereby forming the storage node layers 140.

Then, blocking insulating layers 150 are formed on the storage node layers 140. For example, an oxide layer, a nitride layer or a high-k dielectric layer is formed using CVD, and predetermined portions are selectively removed, thereby forming the blocking insulating layers 150.

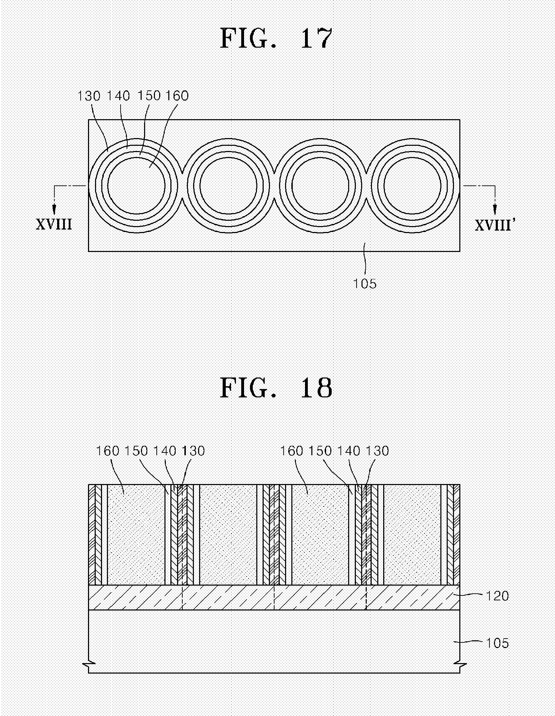

Referring to FIGS. 17 and 18, control gate electrodes 160 are formed on the blocking insulating layers 150 to be filled into the holes 115 and recessed inside the semiconductor substrate 105. For example, after a conductive layer is filled into the holes 115 and then planarized, the control gate electrodes 160 are formed.

Thereafter, the semiconductor memory device is completed according to a method well-known to one of ordinary skill in the art. In the current embodiment, the semiconductor memory device can be economically manufactured, using a typical bulk semiconductor wafer.

Although the method of fabricating the semiconductor memory device illustrated in FIGS. 5 and 6 is described as an example in the current embodiment, it is obvious to one of ordinary skill in the art that the current method can be easily modified and applied to fabricate another semiconductor memory device.

While the present invention has been particularly shown and described with reference to exemplary embodiments thereof, it will be understood by one of ordinary skill in the art that various changes in form and details may be made therein without departing from the scope of the present invention as defined by the following claims.

## Claims

1. A semiconductor memory device comprising:
a semiconductor substrate;
a control gate electrode recessed inside the semiconductor substrate;
a storage node layer interposed between a sidewall of the control gate electrode and the semiconductor substrate;
a tunneling insulating layer interposed between the storage node layer and the semiconductor substrate;
a blocking insulating layer interposed between the storage node layer and the control gate electrode; and
first and second channel regions formed around a surface of the semiconductor substrate under the tunneling insulating layer to surround the control gate electrode, and separated by a pair of separation insulating layers that face each other.

2. The semiconductor memory device of claim 1, wherein the control gate electrode has a cylindrical, elliptical, or polygonal shape.

3. The semiconductor memory device of claim 2, wherein the storage node layer, the tunneling insulating layer, and the blocking insulating layer are formed along the sidewall of the control gate electrode.

4. The semiconductor memory device of claim 2, wherein the control gate electrode is formed symmetrically about a line connecting the pair of separation insulating layers.

5. The semiconductor memory device of any preceding claim, further comprising a buried insulating layer interposed between a bottom of the control gate electrode and the semiconductor substrate, and thicker than the tunneling insulating layer.

6. The semiconductor memory device of any preceding claim, wherein the storage node layer comprises a polysilicon layer, a silicon nitride layer, metal or silicon dots, or metal or silicon nano-crystals.

7. A semiconductor memory device comprising:
a semiconductor substrate;
a plurality of control gate electrodes respectively recessed inside the semiconductor substrate;
a plurality of storage node layers respectively interposed between the sidewalls of the plurality of control gate electrodes and the semiconductor substrate;
a plurality of tunneling insulating layers respectively interposed between the plurality of storage node layers and the semiconductor substrate, and adjacent pairs of the plurality of storage node layers contacting with each other to separate the semiconductor substrate into first and second regions;
a plurality of blocking insulating layers respectively interposed between the plurality of storage node layer and the plurality of control gate electrodes;
a continuous first channel region surrounding portions of sidewalls of the plurality of control gate electrodes, around the surface of the first region of the semiconductor substrate; and
a continuous second channel region surrounding the other portions of the sidewalls of the plurality of control gate electrodes around the surface of the second region of the semiconductor substrate.

8. The semiconductor memory device of claim 7, wherein the plurality of control gate electrodes have a cylindrical, elliptical, or polygonal shape.

9. The semiconductor memory device of claim 8, wherein the plurality of storage node layers, the plurality of tunneling insulating layers, and the plurality of blocking insulating layers are formed along the sidewalls of the plurality of control gate electrodes.

10. The semiconductor memory device of claim 9, wherein the plurality of control gate electrodes are polygonal bar shaped, and corners of adjacent pairs of the plurality of tunneling insulating layers contact each other.

11. The semiconductor memory device of claim 7, 8, 9 or 10, wherein the first channel region and the second channel region are symmetrically formed.

12. The semiconductor memory device of any of claims 7 to 11, further comprising a plurality of buried insulating layers respectively interposed between bottoms of the plurality of control gate electrodes and the semiconductor substrate, and thicker than the plurality of tunneling insulating layers.

13. The semiconductor memory device of any of claims 7 to 12, wherein the plurality of storage node layers comprise a polysilicon layer, a silicon nitride layer, metal or silicon dots, or metal or silicon nano-crystals.

14. The semiconductor memory device of any of claims 7 to 13, wherein the first channel region and the second channel region are used as separate bit lines.

15. A method of fabricating a semiconductor memory device, comprising:
etching a semiconductor substrate to form a plurality of holes;
forming a plurality of tunneling insulating layers on semiconductor substrate portions of sidewalls of the plurality of holes so that adjacent pairs of the plurality of tunneling insulating layers contact each other in order to separate the semiconductor substrate into first and second regions;
forming a plurality of storage node layers on the plurality of tunneling insulating layers;
forming blocking insulating layers on the storage node layers; and
forming control gate electrodes on the blocking insulating layers to be filled into the plurality of holes and recessed into the inside of the semiconductor substrate.

16. The method of claim 15, further comprising annealing the semiconductor substrate having the plurality of holes by using hydrogen vapors.

17. The method of claim 15 or 16, further comprising forming a plurality of buried insulating layers on the semiconductor substrate portions of bottoms of the plurality of holes, the buried insulating layers being thicker than the tunneling insulating layer.

18. The method of claim 15, 16 or 17, wherein the plurality of control gate electrodes have a cylindrical, elliptical, or polygonal shape.

19. The method of claim 18, wherein the plurality of control gate electrodes have a polygonal bar shape, and corners of adjacent pairs of the plurality of tunneling insulating layers contact each other.

20. The method of any of claims 15 to 19, wherein the plurality of storage node layers each comprise a polysilicon layer, a silicon nitride layer, metal or silicon dots, or metal or silicon nano-crystals.

21. The method of any of claims 15 to 20, wherein the forming of the plurality of tunneling insulating layers is achieved by thermal oxidation of the sidewalls of the semiconductor substrate exposed by the plurality of holes.
